(19) Europäisches Patentamt
European Patent Office
Office européen des brevets

(11) **EP 1 467 491 B1**

(12) **EUROPÄISCHE PATENTSCHRIFT**

(45) Veröffentlichungstag und Bekanntmachung des Hinweises auf die Patenterteilung:
**24.01.2007 Patentblatt 2007/04**

(51) Int Cl.:
*G06T 9/00* (2006.01)      *H03M 7/40* (2006.01)
*H04N 7/30* (2006.01)

(21) Anmeldenummer: **04016773.6**

(22) Anmeldetag: **02.05.2003**

(54) **Arithmetische Codierung von Transformationskoeffizienten**

Arithmetical coding of transform coefficients

Codage arithmétique des coefficients de transformée

(84) Benannte Vertragsstaaten:
**AT BE BG CH CY CZ DE DK EE ES FI FR GB GR HU IE IT LI LU MC NL PT RO SE SI SK TR**

(30) Priorität: **02.05.2002 DE 10220961**

(43) Veröffentlichungstag der Anmeldung:
**13.10.2004 Patentblatt 2004/42**

(62) Dokumentnummer(n) der früheren Anmeldung(en) nach Art. 76 EPÜ:
**03725142.8 / 1 500 281**

(73) Patentinhaber: **Fraunhofer-Gesellschaft zur Förderung der angewandten Forschung e.V.**
**80686 München (DE)**

(72) Erfinder:
• **Schwarz, Heiko**
  **13187 Berlin (DE)**
• **Marpe, Detlef**
  **12161 Berlin (DE)**
• **Wiegand, Thomas**
  **10789 Berlin (DE)**

(74) Vertreter: **Schenk, Markus et al**
**Patentanwälte Schoppe, Zimmermann Stöckeler & Zinkler**
**Postfach 246**
**82043 Pullach (DE)**

(56) Entgegenhaltungen:
• **MARPE D ET AL: "Video compression using context-based adaptive arithmetic coding" PROCEEDINGS 2001 INTERNATIONAL CONFERENCE ON IMAGE PROCESSING. ICIP 2001. THESSALONIKI, GREECE, OCT. 7 - 10, 2001, INTERNATIONAL CONFERENCE ON IMAGE PROCESSING, NEW YORK, NY : IEEE, US, Bd. VOL. 1 OF 3. CONF. 8, 7. Oktober 2001 (2001-10-07), Seiten 558-561, XP010563407 ISBN: 0-7803-6725-1**
• **TEUHOLA J: "A COMPRESSION METHOD FOR CLUSTERED BIT-VECTORS" INFORMATION PROCESSING LETTERS, AMSTERDAM, NL, Bd. 7, Nr. 6, Oktober 1978 (1978-10), Seiten 308-311, XP001000934 ISSN: 0020-0190**
• **MOFFAT A ET AL: "Chapter 3. Static Codes" COMPRESSION AND CODING ALGORITHMS, Februar 2002 (2002-02), Seiten 29-50, XP002312370 KLUWER ACADEMIC PUBLISHERS, BOSTON, US**

**Beschreibung**

Die vorliegende Erfindung beschreibt ein Verfahren und eine Anordnung zur Kodierung von Transformations-Koeffizienten in Bild- und/oder Videokodierern und -dekodierern sowie ein entsprechendes Computerprogramm und ein entsprechendes computerlesbares Speichermedium, welche insbesondere als ein neues effizientes Verfahren zur binären arithmetischen Kodierung von Transformations-Koeffizienten im Bereich der Videokodierung (CABAC in H. 264/AVC, vgl. [1]) eingesetzt werden können.

In den gegenwärtigen hybriden block-basierten Standards zur Videokodierung wie beispielsweise MPEG-2 [2], H.263 [3] und MPEG-4 [4] werden die Blöcke von quantisierten Transformations-Koeffizienten (Levels) durch einen definierten Scan-Vorgang auf einen Vektor abgebildet, welcher durch die Verwendung einer Lauflängen-Kodierung und einer anschließenden Abbildung auf Kodeworte variabler Länge kodiert wird.

In MPEG-2 [2] werden die Kodeworte variabler Länge 2 dimensionalen Ereignissen (RUN, LEVEL) zugewiesen, wobei LEVEL den quantisierten Wert eines nicht zu Null quantisierten (signifikanten) Transformations-Koeffizienten repräsentiert; die Lauflänge RUN gibt die Anzahl der aufeinander folgenden, zu Null quantisierten (nichtsignifikanten) Transformations-Koeffizienten an, welche in dem Vektor von Transformations-Koeffizienten unmittelbar vor dem gegenwärtigen signifikanten Transformations-Koeffizienten liegen. Zusätzlich werden Kodeworte variabler Länge für die zwei spezielle Ereignisse EOB und ESCAPE definiert. Während, das EOB-Ereignis angibt, dass keine weiteren signifikanten Transformations-Koeffizienten in dem Block vorhanden sind, signalisiert das ESCAPE-Ereignis, dass das vorhandene Ereignis (RUN, LEVEL) nicht durch das definierte Alphabet von Kodeworten variabler Länge repräsentiert werden kann. In diesem Fall, werden die Symbole RUN und LEVEL durch Kodeworte fester Länge kodiert.

In den neueren Kodier-Standards H.263 [3] und MPEG-4 [4] erfolgt die Zuordnung von Kodeworten variabler Länge auf der Basis von 3-dimensionalen Ereignissen (LAST, RUN, LEVEL), wobei das binäre Symbol LAST angibt, ob der gegenwärtige signifikante Transformations-Koeffizient der letzte signifikante Koeffizient innerhalb des Blockes ist oder ob noch weitere signifikante Transformations-Koeffizienten folgen. Durch die Verwendung dieser 3-dimenionalen Ereignisse wird kein zusätzliches EOB-Ereignis benötigt; ein ESCAPE-Ereignis wird analog zu MPEG-2 verwendet, wobei zusätzlich zu RUN und LEVEL noch das binäre Symbol LAST kodiert wird.

Die in MPEG-2, H.263 und MPEG-4 realisierte Kodierung der Transformations-Koeffizienten weist folgende Nachteile auf:

- Jedem Kodier-Ereignis kann nur ein Kodewort ganzzahliger Länge zugeordnet werden, eine effiziente Kodierung von Ereignissen mit Wahrscheinlichkeiten größer 0.5 ist nicht geweben.
- Die Verwendung einer festen Tabelle für die Abbildung der Kodier-Ereignisse auf die Kodeworte variabler Länge für alle Transformations-Koeffizienten innerhalb eines Blockes berücksichtigt nicht die positions- bzw. frequenzabhängigen Symbol-Statistiken.
- Es ist keine Adaption an die tatsächlich vorhandenen Symbol-Statistiken möglich.
- Es erfolgt keine Ausnutzung der vorhandenen Inter-Symbol-Redundanzen.

Der Annex E des H.263-Standards spezifiziert eine optionale, nicht-adaptive arithmetische Kodierung, bei welcher verschiedene, fest vorgegebene Modell-Wahrscheinlichkeitsverteilungen verwendet werden,

- eine jeweils für das erste, zweite und dritte Ereignis (LAST,RUN,LEVEL)/ESCAPE
- eine weitere für alle folgenden Ereignisse (LAST,RUN,LEVEL)/ESCAPE eines Blocks von Transformations-Koeffizienten,
- sowie jeweils eine weitere für die Symbole LAST, RUN und LEVEL, welche nach einem ESCAPE-Ereignis kodiert werden.

Durch diese optionale arithmetische Kodierung ist jedoch aus folgenden Gründen keine nennenswerte Steigerung der Kodier-Effizienz möglich:

- Der Vorteil der arithmetischen Kodierung, dass einem Kodier-Ereignis ein Kodewort nicht-ganzzahliger Länge zugewiesen werden kann, hat durch die Verwendung kombinierter Ereignisse der Form (LAST, RUN, LEVEL) kaum Auswirkungen auf die Kodier-Effizienz.
- Der Vorteil der Verwendung verschiedener Wahrscheinlichkeits-Verteilungen wird dadurch aufgehoben, dass keine Adaption an die tatsächlich vorhandenen Symbol-Statistiken möglich ist.

Eine der ersten veröffentlichten Verfahren zur Kodierung von Transformations-Koeffizienten durch eine adaptive binäre arithmetische Kodierung in einem hybriden Videokodierer, welches die Adaption der Wahrscheinlichkeiten an die vorhandenen Symbol-Statistiken gewährleistet, wurde in [5] vorgestellt.

In H.264/AVC [1] wird als Standard-Methode zur EntropieKodierung ein kontext-adaptives Verfahren auf der Basis von Kodeworten variabler Länge für die Codierung von Transformations-Koeffizienten spezifiziert. Hierbei wird die Codierung eines Blockes von Transformations-Koeffizienten durch folgende Merkmale bestimmt:

-   Durch ein Symbol COEFF_TOKEN wird sowohl die Anzahl der signifikanten Koeffizienten innerhalb eines Blocks als auch die Anzahl der aufeinander folgenden zu Eins quantisierten Koeffizienten am Ende des Vektors von Transformations-Koeffizienten bestimmt. In Abhängigkeit vom Block-Typ sowie von bereits kodierten/dekodierten Symbolen COEFF_TOKEN für benachbarte Blöcke wird für die Kodierung eine von fünf definierten Kodewort-Tabellen ausgewählt.

-   Während für die zu Eins quantisierten Transformations-Koeffizienten am Ende des Koeffizienten-Vektors nur ein einzelnes Bit zur Spezifikation des Vorzeichens übertragen wird, erfolgt die Kodierung der Werte (Levels) der restlichen signifikanten Transformations-Koeffizienten in umgekehrter Scan-Reihenfolge mittels eines kombinierten Prefix-Suffix-Kodewortes.

-   Ist die Anzahl der signifikanten Transformations-Koeffizienten kleiner als die Anzahl der Transformations-Koeffizienten für den entsprechenden Block, wird ein Symbol TOTAL_ZEROS kodiert, welches die Anzahl der zu Null quantisierten Transformations-Koeffizienten, die im Koeffizienten-Vektor vor dem letzten signifikanten Koeffizienten liegen, angibt. Hierfür wurden achtzehn Kodewort-Tabellen spezifiziert, die in Abhängigkeit von der Anzahl der signifikanten Koeffizienten und des Block-Typs geschaltet werden.

-   Die Lauflänge der zu Null quantisierten (nichtsignifikanten) Koeffizienten (RUN) vor einem signifikanten Koeffizienten wird für jeden signifikanten Transformations-Koeffizienten in umgekehrter Scan-Reihenfolge kodiert, solange die Summe der bereits kodierten RUN's kleiner ist als TOTAL_ZEROS. In Abhängigkeit von TOTAL_ZEROS und der bereits kodierten/dekodierten RUN's wird hierbei zwischen sieben Kodewort-Tabellen geschaltet.

Obwohl dieses sogenannte CAVLC-Verfahren (CAVLC: Context-Adaptive Variable Length Coding) durch die kontext-basierte Schaltung der Kodewort-Tabellen eine deutlich effizientere Kodierung der Transformations-Koeffizienten erlaubt als die in MPEG-2, H.263 und MPEG-4 spezifizierten Methoden, weist es im wesentlichen die folgenden Nachteile auf:

-   Es wird zwar eine Schaltung zwischen verschiedenen Kodewort-Tabellen in Abhängigkeit von bereits kodierten/ dekodierten Symbolen vorgenommen, die Kodewort-Tabellen können jedoch nicht an die tatsächlichen Symbol-Statistiken angepasst werden.

-   Durch die Verwendung von Kodeworten variabler Länge lassen sich Ereignisse mit Symbol-Wahrscheinlichkeiten größer 0.5 nicht effizient kodieren. Diese Beschränkung verhindert insbesondere die Kodierung von Symbolen mit einem kleineren Wertebereich, wodurch unter Umständen eine Konstruktion geeigneterer Kontexte für die Schaltung zwischen verschiedenen Modell-Wahrscheinlichkeitsverteilungen möglich wäre.

Eine mögliche Lösung zur Vermeidung der dargestellten Nachteile der bekannten Verfahren zur Kodierung von Transformations-Koeffizienten in block-basierten Bild- und Videokodierern stellt eine Kombination aus einer adaptiven arithmetischen Kodierung und einer geeigneten Kontext-Bildung zur Ausnutzung der Inter-Symbol-Redundanzen dar. Da der erhöhte Rechenaufwand der arithmetischen Kodierung im Vergleich zur Kodierung mittels Kodeworten variabler Länge einen Nachteil darstellt, ist hierbei insbesondere auf die Möglichkeit eine effizienten Hardware- und Software-Implementierung Rücksicht zu nehmen.

In Marpe, Blättermann, Heising und Wiegand: "Video compression using context-based adaptive arithmetic coding", Proceedings 2001 International Conference on Image Processing, ICIP 2001, 7.-10. Oktober 2001, Bd. 1, S. 558-561 wird eine kontextbasierte adaptive Entropiekodierung beschrieben, nach welcher ein gegebenes nicht-binarisiertes Symbol im Rahmen einer Binarisierung in eine Folge von Bins umgewandelt wird, deren einzelne Bins dann einer adaptiven binären arithmetischen Kodierung unterzogen werden. Es wird ferner offenbart, dass es vorteilhaft ist, unterschiedliche Kontextmodelle für unterschiedliche Bin-Positionen in der Bin-Folge zu verwenden. Ein Vorteil der Verwendung einer binären arithmetischen Kodierung anstelle einer üblichen M-Symbol-Kodierung bestünde darin, dass die Kontextmodelle auf einen kleinen Teilsatz der Bin-Positionen beschränkt werden könne. Der Artikel geht ferner darauf ein, dass bereits Kontextmodelle zur Kodierung von Syntaxelementen entworfen wurden, die sich auf Bewegungs-, Modus- und Texturinformationen beziehen. Als Beispiel einer Binarisierung wird lediglich eine unäre Binarisierung vorgeschlagen.

In Teuhola: " A compression method for clustered bitvectors", Information Processing Letters, Bd. 7, Nr. 6, Oktober 1978, S. 308-311 wird ein Kompressionsverfahren für gehäufte Bit-Vektoren beschrieben. Zur Kodierung solcher gehäuften Vektoren stünden verschiedene Verfahren zur Verfügung, die sich in eine Fest-zu-Variabel-, Variabel-zu-Fest- und Variabel-zu-Variabel-Kodierung unter untergliedern ließen. Das Dokument schlägt nun zur Kodierung von gehäuften Bit-Vektoren eine Variabel-zu-Variabel-Kodierung nach Art einer Lauflängen-Kodierung unter Verwendung eines EXP-Golomb-Codes vor.

In Moffat et al.: "Chapter 3. Static Codes", in Compression and coding algorithms, Februar 2002, S. 29-50 beschäftigt man sich mit statischen Codes im Allgemeinen. Diese ignorierten die zur Verfügung stehenden Wahrscheinlichkeiten oder machten lediglich minimale Verwendung von denselben. Deshalb seien statische Codes sehr einfach, wiewohl ihre Kompressionseffektivität schwach sei. Einige Kompressionsanwendungen jedoch seien derart, dass die Ursprungswahrscheinlichkeiten eine solche Verteilung besäßen, dass die regelmäßige Natur der statischen Codes hierfür sehr geeignet sei. Insbesondere wird dort die Übersetzung eines Quellalphabetes in ein Zielalphabet unter Verwendung von statischen Codes beschrieben. Die dort beschriebenen Codes umfassen unäre und binäre Codes, Elias-Codes und Golomb- und Rice-Codes. Ein Golomb-Code wird als ein Code mit minimaler Redundanz für eine geometrische Verteilung hervorgehoben. Ein EXP-Golomb-Code wird in dem Dokument unter der Bezeichnung Elias-$C_y$-Code beschrieben.

Die Aufgabe der Erfindung besteht somit darin, ein Verfahren und eine Anordnung zur Kodierung von Transformations-Koeffizienten in Bild- und/oder Videokodierern und -dekodierern sowie ein entsprechendes Computerprogramm und ein entsprechendes computerlesbares Speichermedium bereitzustellen, welche die oben genannten Mängel beheben und insbesondere den zur Kodierung erforderlichen Rechenaufwand gering halten.

Diese Aufgabe wird erfindungsgemäß durch das in Anspruch 1 definierte Verfahren, durch das in Anspruch 3 definierte Verfahren, durch die in Anspruch 6 definierte Vorrichtung, durch die in Anspruch 7 definierte Vorrichtung, durch das in Anspruch 8 definierte Computerprogramm sowie durch das in Anspruch 9 definierte computerlesbare Speichermedium gelöst. Zweckmäßige Ausgestaltungen der Erfindung sind in den Unteransprüchen enthalten.

Für signifikante Transformations Koeffizienten enthaltende Blöcke von (Video-)Bildern kann eine Kodierung der Transformations-Koeffizienten derart erfolgen, dass für jeden Block

- in einem Scan-Vorgang die Positionen von signifikanten Transformations-Koeffizienten in dem Block und anschließend

- in umgekehrter Scan-Reihenfolge - beginnend mit dem letzten signifikanten Transformations-Koeffizienten innerhalb des Blocks - die Werte (Levels) der signifikanten Transformations-Koeffizienten

ermittelt und kodiert werden.

Jeder vom letzten Transformations-Koeffizienten des Blocks verschiedene signifikante Transformations-Koeffizient des Blocks kann durch ein Ein-Bit-Symbol gekennzeichnet werden.

Dabei kann für jeden signifikanten Transformations-Koeffizienten das Vorzeichen durch ein Ein-Bit-Symbol (SIGN) und der Betrag durch ein binär kodiertes Symbol (ABS) angegeben werden.

Zudem können signifikante Transformations-Koeffizienten enthaltende Blöcke durch ein Ein-Bit-Symbol CBP4 im Zusammenhang mit weiteren SyntaxElementen wie beispielsweise CBP oder Makroblock-Mode gekennzeichnet werden.

Durch die Übertragung eines Ein-Bit-Symbols SIG für jeden Koeffizienten eines Blocks und eines Ein-Bit-Symbols LAST für jeden signifikanten Koeffizienten eines Blocks kann eine Signifikanz-Abbildung kodiert werden, wobei die Übertragung in Scan-Reihenfolge erfolgt, SIG der Kennzeichnung von signifikanten Koeffizienten dient und LAST angibt, ob in dem Block weitere signifikante Transformations-Koeffizienten vorhanden sind.

Die Modellierung für das Ein-Bit-Symbol CBP4, für die Kodierung der Signifikanz-Abbildung und/oder für die Kodierung der Koeffizienten-Beträge kann kontextabhängig erfolgen. Dabei ist vorgesehen, dass Block-Typen von Transformations-Koeffizienten mit vergleichbaren Statistiken zu Block-Kategorien zusammengefasst werden.

für die letzte Scan-Position eines Blockes kann die Übertragung der Signifikanz-Information (SIG, LAST) unterbleiben.

Der Betrag (ABS) kann durch ein Symbol in unärer Binarisierung oder durch ein einen Präfix-Teil und einen Suffix-Teil aufweisendes Symbol angegeben werden, wobei der Präfix-Teil aus Einsen besteht und der Suffix-Teil in einem Exp-Golomb-Code 0-ter Ordnung kodiert wird.

Die Kodierung von Transformations-Koeffizienten kann beispielweise folgendermaßen umschrieben werden:

Ein zweidimensionaler Block von Transformations-Koeffizienten wird durch einen Scan-Vorgang auf einen eindimensionalen Vektor abgebildet.
- Die in bekannten Verfahren verwendeten Syntax-Elemente des EOB-Symbols, des LAST-Symbols oder des Koeffizienten-Zählers (Anzahl der signifikanten Koeffizienten) sowie des RDN's (Anzahl nichtsignifikanter Koeffizienten in Scan-Reihenfolge) werden durch ein Ein-Bit-Symbol CBP4 und eine Signifikanz-Abbildung ersetzt.
- Die Levels (Beträge der signifikanten Koeffizienten) werden in umgekehrter Scan-Reihenfolge kodiert
- Eine Kontext-Modellierung erfolgt.

Die Erfindung wird nachfolgend unter Bezugnahme auf die Figuren der Zeichnungen an einem Ausführungsbeispiel näher erläutert. Es zeigen:

Fig. 1   Veranschaulichung des Grundprinzips der Kodierung von Transformations-Koeffizienten gemäß dem erfindungsgemäßen Kodierungsverfahren,

Fig. 2   zwei Beispiele für die Kodierung der Signifikanz-Abbildung (die gelb markierten Symbole werden nicht übertragen),

Fig. 3   Binarisierung für die Beträge der Transformations-Koeffizienten (ABS),

Fig. 4   Block-Typen und deren Klassifikation für den H.264/AVC-Standard,

Fig. 5   Kontext-Modellierung für das Ein-Bit-Symbol CBP4 und

Fig. 6   Beispiele der Kontext-Modellierung für die Kodierung der Beträge der signifikanten Transformations-Koeffizienten.

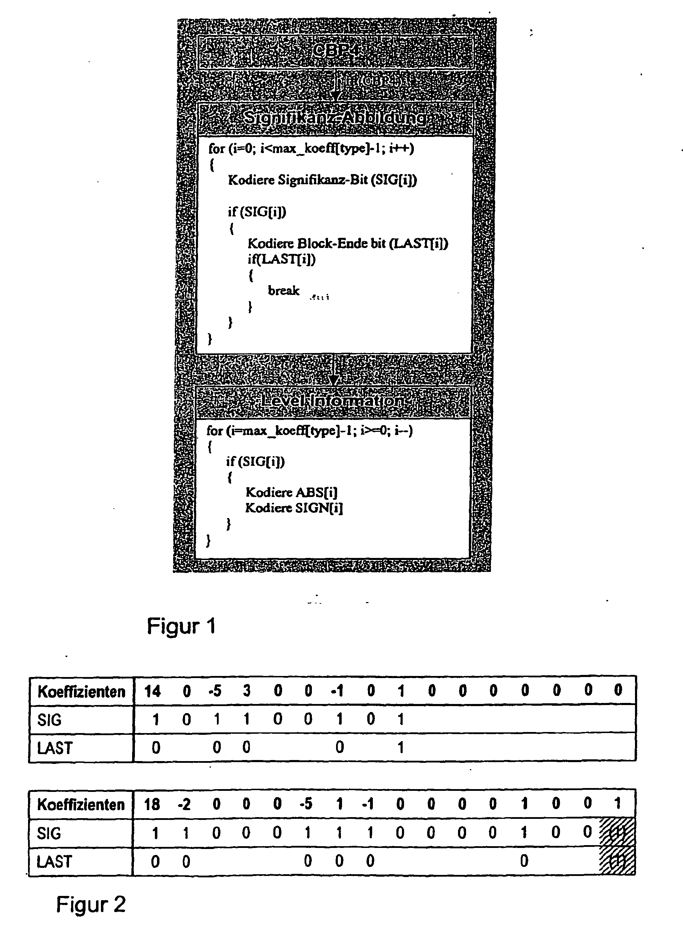

Figur 1 veranschaulicht das neue Kodierungsverfahren. Für jeden Block von Transformations-Koeffizienten wird zuerst ein Ein-Bit-Symbol CBP4 übertragen, es sei denn, höhergeordnete Syntax-Elemente (CBP oder Makroblock-Mode) zeigen bereits an, dass der betrachtete Block keine signifikanten Transformations-Koeffizienten enthält. Das CBP4-Symbol ist Null, wenn keine signifikanten Koeffizienten in dem Block vorhanden sind. Ist es Eins, wird eine Signifikanz-Abbildung kodiert, welche die Position (in Scan-Reihenfolge) der signifikanten Transformations-Koeffizienten spezifiziert. Anschließend werden die Beträge sowie die Vorzeichen der signifikanten Koeffizienten in umgekehrter Scan-Reihenfolge übertragen. Eine detaillierte Beschreibung des Kodierungsprozesses wird unten in Punkt 1 gegeben. Anschließend wird in Punkt 2 die Kontext-Modellierung für die binäre arithmetische Kodierung beschrieben.

## 1. Beschreibung der Kodierung der Transformations-Koeffizienten

### 1.1 Abtastung (Scan) der Tranformations-Koeffizienten

Die Transformations-Koeffizienten eines jeden Blocks werden mittels eines Scan-Vorgangs (zum Beispiel Zig-Zag-Scan) auf einen Vektor abgebildet.

### 1.2 Das CBP4-Symbol

CBP4 ist ein Ein-Bit-Symbol, welches angibt, ob signifikante Transformations-Koeffizienten (Transformations-Koeffizienten ungleich Null) in einem Block vorhanden sind. Ist das CBP4-Symbol Null, werden keine weiteren Informationen für den entsprechenden Block übertragen.

### 1.3 Die Signifikanz-Abbildung

Gibt das CBP4-Symbol an, dass der entsprechende Block signifikante Koeffizienten enthält, wird eine Signifikanz-Abbildung kodiert. Dies erfolgt durch die Übertragung eines Ein-Bit-Symbols (SIG) für jeden Koeffizienten in Scan-Reihenfolge. Ist ein entsprechendes Signifikanz-Symbol Eins (signifikanter Koeffizient), wird ein weiteres Ein-Bit-Symbol (LAST) gesendet. Dieses Symbol gibt an, ob der gegenwärtige signifikante Koeffizient der letzte signifikante Koeffizient innerhalb des Blockes ist oder ob weitere signifikante Koeffizienten folgen. Die Figur 2 zeigt zwei Beispiele für die beschriebene Methode zur Kodierung der Signifikanz-Abbildung. Für die letzte Scan-Position eines Blockes wird niemals eine Signifikanz-Information (SIG, LAST) übertragen. Wurde die Übertragung der Signifikanz-Abbildung nicht bereits durch ein LAST-Symbol von Eins beendet, ist es offensichtlich, dass der Koeffizient an der letzten Scan-Position signifikant ist (siehe gelb markierte Position in Figur 2).

### 1.4 Die Level-Information

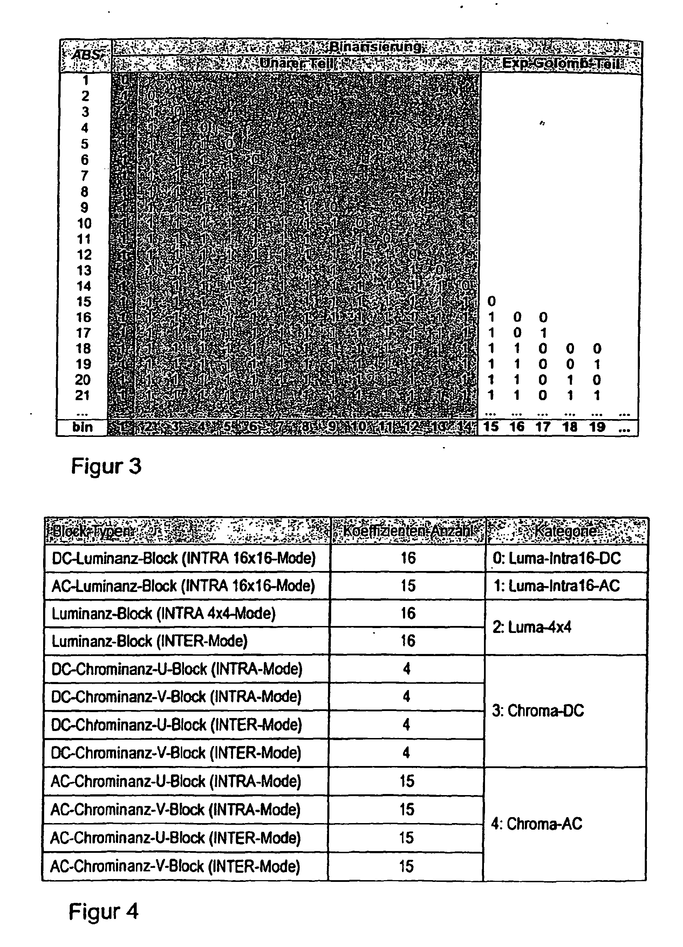

Durch die Signifikanz-Abbildung werden die Positionen der signifikanten Transformations-Koeffizienten innerhalb eines Blockes eindeutig spezifiziert. Die Kodierung der genauen Werte der Koeffizienten (Levels) erfolgt durch zwei Kodierungssymbole: ABS (Betrag der Koeffizienten) und SIGN (Vorzeichen der Koeffizienten). Während SIGN ein Ein-Bit-Symbol darstellt, wird zur Kodierung der Beträge der Koeffizienten (ABS) eine Binarisierung nach Figur 3 verwendet. Für Koeffizienten-Beträge im Intervall [1; 14] entspricht diese Binarisierung einer unären Binarisierung. Die Binarisierung für Koeffizienten-Beträge größer 14 setzt sich aus einem Präfix-Teil, der aus 14 Einsen besteht, und einem Suffix-Teil, der einen Exp-Golomb-Code 0-ter Ordnung für das Symbol (ABS-15) darstellt, zusammen. Die Binarisierung umfasst keine Repräsentation für Koeffizienten-Beträge (ABS) gleich 0, da signifikante Koeffizienten (Koeffizienten ungleich Null) stets einen Betrag (ABS) größer oder gleich Eins aufweisen.

Die aus einem Präfix-Teil und einem durch einen Exp-Golomb-Code 0-ter Ordnung bestehenden Suffix-Teil zusammengesetzten Binarisierung für Koeffizienten-Beträge größer 14 hat den Vorteil, dass ohne Einbußen an Kodier-Effizienz für alle binären Entscheidungen des Suffix-Teil ein spezieller nicht-adaptiver Kontext mit den Symbol-Wahrscheinlichkeiten 0.5 verwendet werden kann, wodurch sich der Rechenaufwand für die Enkodierung und die Dekodierung reduzieren lässt.

Die Levels werden in umgekehrter Scan-Reihenfolge - beginnend mit dem letzten signifikanten Koeffizienten innerhalb eines Blocks - kodiert; dies erlaubt die Bildung geeigneter Kontexte für die binäre arithmetische Kodierung.

## 2. Die Kontext-Modellierung

Im allgemeinen werden im Rahmen eines Bild- und/oder Videokodiersystems verschiedene Typen von Transformations-Koeffizienten-Blöcken unterschieden. So gibt es beispielsweise im gegenwärtigen Final Draft International Standard [1] des H.264/AVC-Standards 12 Typen von Transformations-Koeffizienten-Blöcken, die unterschiedliche Statistiken aufweisen (siehe linke Spalte der Tabelle in Figur 4). Für die meisten Bildsequenzen und Kodierbedingungen sind jedoch einige der Statistiken sehr ähnlich. Um die Anzahl der verwendeten Kontexte gering zu halten und somit eine schnelle Adaption an die Statistiken der zu kodierenden Bildsequenz zu gewährleisten, können beispielsweise die Block-Typen im H.264/AVC-Standard in 5 Kategorien eingeteilt werden (siehe rechte Spalte der Tabelle in Figur 4). Ähnliche Klassifikationen sind für andere Bild- und/oder Videokodiersysteme möglich. Für jede der - im Fall des H. 264/AVC-Standards - fünf Kategorien wird eine eigene Menge von Kontexten für die Symbole CBP4, SIG, LAST, und ABS verwendet.

### 2.1 Kontext-Modellierung für das CBP4-Symbol

Für die Kodierung des Ein-Bit-Symbols CBP4 werden vier unterschiedliche Kontexte für jede einzelne Kategorie von Transformations-Blöcken (siehe Figur 4) verwendet. Die Kontext-Nummer für den zu kodierenden Block C wird durch

$$\texttt{ctx\_number\_cbp4 (C) = CBP4 (A) + 2} \times \texttt{CBP4 (B)}$$

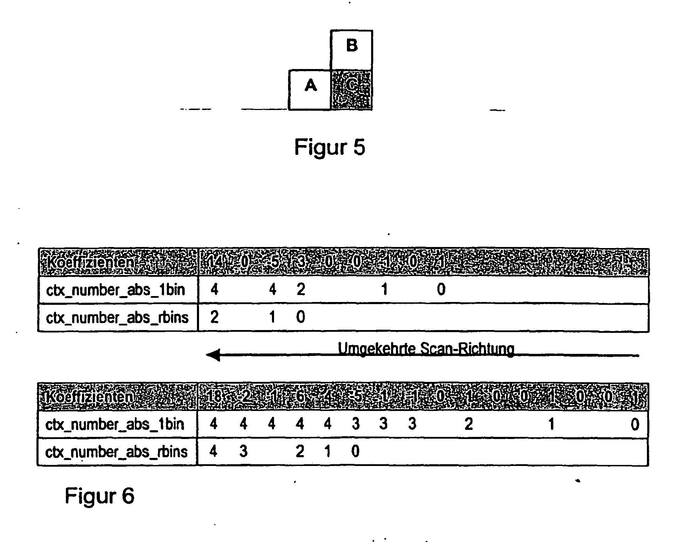

bestimmt, wobei durch A und B diejenigen benachbarten Blöcke (links und oben) des betrachteten Blockes C bezeichnet werden (siehe Abbildung 5), die dem gleichen Block-Typ zuzuordnen sind. Im Rahmen des H.264/AVC-Standards werden für diese Konditionierung folgende 6 Block-Typen unterschieden: Luma-DC, Luma-AC, Chroma-U-DC, Chroma-U-AC, Chroma-V-DC, und Chroma-V-AC. Existiert der betreffende Block X (A oder B) von Transformations-Koeffizienten in einem benachbarten Macroblock nicht (dies ist beispielsweise der Fall, wenn der gegenwärtige Block im INTRA16x16-Mode kodiert wird, der benachbarte Block jedoch im einem INTER-Mode übertragen wurde), wird CBP4 (X) für den benachbarten Block X auf Null gesetzt. Liegt ein benachbarter Block X (A oder B) außerhalb des Bildbereiches oder gehört er zu einer anderen Slice, wird der entsprechende Wert CBP4 (X) durch einen Default-Wert ersetzt. Für INTRA-kodierte Blöcke wird ein Default-Wert von Eins, für INTER-kodierte Blöcke eine Default-Wert von Null verwendet.

### 2.2 Kontext-Modellierung für die Kodierung der Signifikanz-Abbildung

Für die Kodierung der Signifikanz-Abbildung werden pro Block-Kategorie (siehe Figur 4) jeweils max_koeff-1 verschiedene Kontexte für die Kodierung der Symbole SIG und LAST verwendet. Durch max_koeff wird hierbei die Anzahl der Transformations-Koeffizienten für die entsprechende Block-Kategorie (für H.264/AVC, siehe Figur 4) bezeichnet. Die Kontext-Nummer ist stets durch die entsprechende Scan-Position des betrachteten Koeffizienten gegeben. Die Kontext-Nummern eines Koeffizienten koeff[i], der als i-ter Koeffizient gescannt wurde, ergeben sich somit zu

$$\texttt{ctx\_number\_sig(koeff[i]) = ctx\_number\_last(koeff[i]) = i.}$$

Es werden für jede Kategorie von Block-Typen 2xmax_koeff-2 Kontexte für die Kodierung der Signifikanz-Abbildung benutzt.

### 2.3 Kontext-Modellierung für die Kodierung der Koeffizienten-Beträge

Für die Kodierung der Beträge der signifikanten Transformations-Koeffizienten wird die in Figur 3 dargestellte Binarisierung verwendet. Hierbei kommen pro Block-Kategorie zwei unterschiedliche Kontext-Mengen zum Einsatz, eine für die Kodierung der ersten binären Entscheidung bin = 1 (in Figur 3 orange markiert), und eine weitere für die Kodierung der binären Entscheidungen bin = 2..14 (in Figur 3 grün markiert) der Binarisierung. Die Kontext-Nummern werden wie folgt zugewiesen:

```
ctx_number_abs_1bin
    = (koeff mit ABS>1 kodiert ? 4 :
        max(3, Anzahl der kodierten Koeffizienten mit ABS=1)),


ctx_number_abs_rbins
    = max(4, Anzahl der kodierten Koeffizienten mit ABS>1).
```

Die Beträge der Transformations-Koeffizienten werden im umgekehrter Scan-Reihenfolge übertragen. Der Kontext für die erste binären Entscheidung wird durch die Anzahl der bereits übertragenen Koeffizienten (in umgekehrter Scan-Reihenfolge) bestimmt, die einen Betrag von ABS=1 aufweisen. Wurden bereits mehr als 3 Koeffizienten mit dem Betrag ABS=1 übertragen, wird stets der Kontext mit der Nummer 3 gewählt. Sobald ein Koeffizient mit einem Betrag ABS>1 gesendet wurde, wird der Kontext 4 für alle restlichen signifikanten Koeffizienten innerhalb des Blockes verwendet.

Alle binären Entscheidungen mit bin = 2..14 werden unter Verwendung ein und desselben Kontexts kodiert. Hierbei wird die Kontext-Nummer durch die Anzahl der bereits kodierten Koeffizienten (in umgekehrter Scan-Reihenfolge) mit einem Betrag ABS>1 bestimmt, wobei eine Beschränkung auf die maximale Kontext-Nummer von 4 vorgenommen wird. Zur Veranschaulichung sind in der Figur 6 zwei Beispiele für die Kontext-Auswahl bei der Kodierung der Beträge ABS der signifikanten Transformations-Koeffizienten dargestellt.

Für die Kodierung der binären Entscheidungen bin>14 für die Koeffizienten-Beträge sowie für die Vorzeichen SIGN wird ein einzelner nicht-adaptiver Kontext mit den Symbol-Wahrscheinlichkeiten $P_0=P_1=0.5$ verwendet.

Die Erfindung beschränkt sich in ihrer Ausführungsform nicht auf die vorstehend angegebenen bevorzugten Ausführungsbeispiele. Vielmehr ist eine Anzahl von Varianten denkbar, die von der erfindungsgemäßen Anordnung und dem erfindungsgemäßen Verfahren auch bei grundsätzlich anders gearteten Ausführungen Gebrauch machen.

### Quellennachweis

[1] T. Wiegand, G. Sullivan, "Draft Text of Final Draft International Standard (FDIS) of Joint Video Specification (ITU-T Rec. H.264 | ISO/IEC 14496-10 AVC)", JVT-G050, March 2003.

[2] ITU-T and ISO/IEC JTC1, "Generic coding of moving pictures and associated audio information - Part 2: Video", ITU-T Recommendation H.262 - ISO/IEC 13818-2 (MPEG-2), Nov. 1994.

[3] ITU-T, "Video coding for low bitrate communications", ITU-T Recommendation H.263; version 1, Nov. 1995; version 2, Jan. 1998.

[4] ISO/IEC JTC1, "Coding of audio-visual objects - Part 2: Visual", ISO/IEC 14496-2 (MPEG-4 visual version 1), Apr. 1999; Amendment 1 (version 2), Feb. 2000; Amendment 4 (streaming profile), Jan. 2001.

[5] C.A. Gonzales, "DCT coding of motion sequences including arithmetic coder", ISO-IEC/JTC1/SC2/WG8, MPEG 89/187, Aug. 1989.

### Patentansprüche

1. Verfahren zur arithmetischen Kodierung von Beträgen von Transformations-Koeffizienten, mit folgenden Schritten:

Binarisieren der Beträge der Transformations-Koeffizienten in eine Binarisierung, derart, dass für Beträge kleiner gleich einem vorbestimmten Wert die Binarisierung einer unnären Binarisierung entspricht, und dass sich für Beträge größer dem vorbestimmten Wert die Binarisierung aus einem Präfix-Teil, der aus einer dem vorbestimmten Wert entsprechenden Anzahl an Einsen besteht, und einem Suffix-Teil, der einen Exp-Golomb-Teil 0-ter Ordnung für den Betrag des jeweiligen Transformations-Koeffizienten minus dem um Eins inkrementierten vorbestimmten Wert darstellt, zusammensetzt, wobei der vorbestimmte Wert 14 beträgt;

Binäre arithmetische Kodierung von binären Entscheidungen des Suffix-Teils unter Verwendung eines nicht-adaptiven Kontextes; und

Binäre arithmetische Kodierung zumindest einer binären Entscheidung der einer unnären Binarisierung entsprechenden Binarisierung oder des Präfix-Teils unter Verwendung eines Kontextes mit Adaption.

2. Verfahren nach Anspruch 1, bei dem die binäre arithmetische Kodierung der binären Entscheidungen des Suffix-Teils unter Verwendung eines nicht-adaptiven Kontextes unter Verwendung einer Symbolwahrscheinlichkeit von 0,5 durchgeführt wird.

3. Verfahren zur arithmetischen Dekodierung von Beträgen von Transformations-Koeffizienten, die derart binarisiert sind, dass für Beträge kleiner gleich einem vorbestimmten Wert die Binarisierung einer unnären Binarisierung entspricht, und dass sich für Beträge größer dem vorbestimmten Wert die Binarisierung aus einem Präfix-Teil, der aus einer dem vorbestimmten Wert entsprechenden Anzahl an Einsen besteht, und einem Suffix-Teil, der einen Exp-Golomb-Teil 0-ter Ordnung für den Betrag des jeweiligen Transformations-Koeffizienten minus dem um Eins inkrementierten vorbestimmten Wert darstellt, zusammensetzt, wobei der vorbestimmte Wert 14 beträgt, mit folgenden Schritten:

Binäre arithmetische Dekodierung von binären Entscheidungen des Suffix-Teils unter Verwendung eines nicht-adaptiven Kontextes; und

Binäre arithmetische Dekodierung zumindest einer binären Entscheidung der einer unnären Binarisierung entsprechenden Binarisierung oder des Präfix-Teils unter Verwendung eines Kontextes mit Adaption.

4. Verfahren nach Anspruch 3, bei dem die binäre arithmetische Dekodierung der binären Entscheidungen des Suffix-Teils unter Verwendung eines nicht-adaptiven Kontextes unter Verwendung einer Symbolwahrscheinlichkeit von 0,5 durchgeführt wird.

5. Verfahren nach einem der vorhergehenden Ansprüche, bei dem die Binarisierung derart durchgeführt wird, dass die Beträge durch ein Symbol (ABS) in unärer Binarisierung oder durch ein einen Präfix-Teil und einen Suffix-Teil aufweisendes Symbol (ABS) angegeben werden, und dass der Präfix-Teil aus Einsen besteht und der Suffix-Teil in einem Exp-Golomb-Code 0-ter Ordnung kodiert ist.

6. Vorrichtung zur arithmetischen Kodierung von Beträgen von Transformations-Koeffizienten, mit folgenden Merkmalen:

einer Einrichtung zum Binarisieren der Beträge der Transformations-Koeffizienten in eine Binarisierung, derart, dass für Beträge kleiner gleich einem vorbestimmten Wert die Binarisierung einer unnären Binarisierung entspricht, und dass sich für Beträge größer dem vorbestimmten Wert die Binarisierung aus einem Präfix-Teil, der aus einer dem vorbestimmten Wert entsprechenden Anzahl an Einsen besteht, und einem Suffix-Teil, der einen Exp-Golomb-Teil 0-ter Ordnung für den Betrag des jeweiligen Transformations-Koeffizienten minus dem um Eins inkrementierten vorbestimmten Wert darstellt, zusammensetzt, wobei der vorbestimmte Wert 14 beträgt;

einer Einrichtung zur binären arithmetischen Kodierung von binären Entscheidungen des Suffix-Teils unter Verwendung eines nicht-adaptiven Kontextes; und

einer Einrichtung zur binären arithmetischen Kodierung zumindest einer binären Entscheidung der einer unnären Binarisierung entsprechenden Binarisierung oder des Präfix-Teils unter Verwendung eines Kontextes mit Adaption.

7. Vorrichtung zur arithmetischen Dekodierung von Beträgen von Transformations-Koeffizienten, die derart binarisiert sind, dass für Beträge kleiner gleich einem vorbestimmten Wert die Binarisierung einer unnären Binarisierung entspricht, und dass sich für Beträge größer dem vorbestimmten Wert die Binarisierung aus einem Präfix-Teil, der aus einer dem vorbestimmten Wert entsprechenden Anzahl an Einsen besteht, und einem Suffix-Teil, der einen Exp-Golomb-Teil 0-ter Ordnung für den Betrag des jeweiligen Transformations-Koeffizienten minus dem um Eins inkrementierten vorbestimmten Wert darstellt, zusammensetzt, wobei der vorbestimmte Wert 14 beträgt, mit folgenden Schritten

einer Einrichtung zur binären arithmetischen Dekodierung von binären Entscheidungen des Suffix-Teils unter Verwendung eines nicht-adaptiven Kontextes; und

einer Einrichtung zur binären arithmetischen Dekodierung zumindest einer binären Entscheidung der einer unnären Binarisierung entsprechenden Binarisierung oder des Präfix-Teils unter Verwendung eines Kontextes mit Adaption.

8. Computerprogramm, das es einem Computer ermöglicht, nachdem es in den Speicher des Computers geladen worden ist, ein Verfahren nach einem der Ansprüche 1 bis 5 durchzuführen.

9. Computerlesbares Speichermedium, auf dem ein Programm gespeichert ist, das es einem Computer ermöglicht, nachdem es in den Speicher des Computers geladen worden ist, ein Verfahren nach einem der Ansprüche 1 bis 5 durchzuführen.

**Claims**

1. A method for arithmetic coding of magnitudes of transform coefficients, comprising:

   binarizing the magnitudes of the transform coefficients into a binarization such that, for magnitudes less than or equal to a predetermined value, the binarization corresponds to a unary binarization, and that, for magnitudes larger than the predetermined value, the binarization is composed of a prefix part consisting of a number of ones corresponding to the predetermined value and a suffix part representing a $0^{th}$ order exp-golomb part for the magnitude of the respective transform coefficient minus the predetermined value incremented by one, wherein the predetermined value is 14;
   binary arithmetic coding of binary decisions of the suffix part using a non-adaptive context; and
   binary arithmetic coding of at least one binary decision of the binarization corresponding to a unary binarization or the prefix part using a context with adaptation.

2. The method of claim 1, wherein the binary arithmetic coding of the binary decisions of the suffix part using a non-adaptive context is performed using a symbol probability of 0.5.

3. A method for arithmetic decoding of magnitudes of transform coefficients binarized such that, for magnitudes less than or equal to a predetermined value, the binarization corresponds to a unary binarization, and that, for magnitudes larger than the predetermined value, the binarization is composed of a prefix part consisting of a number of ones corresponding to the predetermined value and a suffix part representing a $0^{th}$ order exp-golomb part for the magnitude of the respective transform coefficient minus the predetermined value incremented by one, wherein the predetermined value is 14, the method comprising:

   binary arithmetic decoding of binary decisions of the suffix part using a non-adaptive context; and
   binary arithmetic decoding of at least one binary decision of the binarization corresponding to a unary binarization or the prefix part using a context with adaptation.

4. The method of claim 3, wherein the binary arithmetic decoding of the binary decisions of the suffix part using a non-adaptive context is performed using a symbol probability of 0.5.

5. The method of one of the preceding claims, wherein the binarization is done such that the magnitudes are indicated by a symbol (ABS) in unary binarization or by a symbol (ABS) comprising a prefix part and a suffix part, and that the prefix part consists of ones and the suffix part is coded in a $0^{th}$ order exp-golomb code.

6. A device for arithmetic coding of magnitudes of transform coefficients, comprising:

   means for binarizing the magnitudes of the transform coefficients into a binarization such that, for magnitudes less than or equal to a predetermined value, the binarization corresponds to a unary binarization, and that, for magnitudes larger than the predetermined value, the binarization is composed of a prefix part consisting of a number of ones corresponding to the predetermined value and a suffix part representing a $0^{th}$ order exp-golomb part for the magnitude of the respective transform coefficient minus the predetermined value incremented by one, wherein the predetermined value is 14;
   means for binary arithmetic coding of binary decisions of the suffix part using a non-adaptive context; and
   means for binary arithmetic coding of at least one binary decision of the binarization corresponding to a unary binarization or the prefix part using a context with adaptation.

7. A device for arithmetic decoding of magnitudes of transform coefficients binarized such that, for magnitudes less than or equal to a predetermined value, the binarization corresponds to a unary binarization, and that, for magnitudes larger than the predetermined value, the binarization is composed of a prefix part consisting of a number of ones corresponding to the predetermined value and a suffix part representing a $0^{th}$ order exp-golomb part for the magnitude of the respective transform coefficient minus the predetermined value incremented by one, wherein the predetermined value is 14, comprising:

> means for binary arithmetic decoding of binary decisions of the suffix part using a non-adaptive context; and
> means for binary arithmetic decoding of at least one binary decision of the binarization corresponding to a unary binarization or the prefix part using a context with adaptation.

**8.** A computer program allowing a computer to perform a method according to one of claims 1 to 5, after it has been loaded into the memory of the computer.

**9.** A computer-readable storage medium having a program stored thereon allowing a computer to perform a method according to one of claims 1 to 5, after it has been loaded into the memory of the computer.

**Revendications**

**1.** Procédé pour le codage arithmétique de quantités de coefficients de transformation, aux étapes suivantes consistant à :

> binariser les quantités des coefficients de transformation en une binarisation, de sorte que, pour les quantités inférieures ou égales à une valeur prédéterminée, la binarisation corresponde à une binarisation unaire et que, pour les quantités supérieures à la valeur prédéterminée, la binarisation se compose d'un élément de préfixe, qui consiste en un nombre de uns correspondant à la valeur prédéterminée, et d'un élément de suffixe, qui représente un élément Exp-Golomb de l'ordre 0 pour la quantité du coefficient de transformation respectif moins la valeur prédéterminée incrémentée de un, la valeur prédéterminée étant de 14 ;
> soumettre à un codage arithmétique binaire des décisions binaires de l'élément de suffixe à l'aide d'un contexte non adaptatif ; et
> soumettre à un codage arithmétique binaire au moins une décision binaire de la binarisation correspondant à une binarisation unaire ou de l'élément de préfixe à l'aide d'un contexte avec adaptation.

**2.** Procédé selon la revendication 1, dans lequel le codage arithmétique binaire des décisions binaires de l'élément de suffixe à l'aide d'un contexte non adaptatif s'effectue à l'aide d'une probabilité de symbole de 0,5.

**3.** Procédé pour le décodage arithmétique de quantités de coefficients de transformation qui sont binarisées de sorte que, pour les quantités inférieures ou égales à une valeur prédéterminée, la binarisation corresponde à une binarisation unaire et que, pour les quantités supérieures à la valeur prédéterminée, la binarisation se compose d'un élément de préfixe, qui consiste en un nombre de uns correspondant à la valeur prédéterminée, et d'un élément de suffixe, qui représente un élément Exp-Golomb de l'ordre 0 pour la quantité du coefficient de transformation respectif moins la valeur prédéterminée incrémentée de un, la valeur prédéterminée étant de 14, aux étapes suivantes consistant à :

> soumettre à un décodage arithmétique binaire des décisions binaires de l'élément de suffixe à l'aide d'un contexte non adaptatif ; et
> soumettre à un décodage arithmétique binaire au moins une décision binaire de la binarisation correspondant à une binarisation unaire ou de l'élément de préfixe à l'aide d'un contexte avec adaptation.

**4.** Procédé selon la revendication 3, dans lequel le décodage arithmétique binaire des décisions binaires de l'élément de suffixe à l'aide d'un contexte non adaptatif s'effectue à l'aide d'une probabilité de symbole de 0,5.

**5.** Procédé selon l'une des revendications précédentes, dans lequel la binarisation s'effectue de sorte que les quantités soient indiquées par un symbole (ABS) en binarisation unaire ou par un symbole (ABS) présentant un élément de préfixe et un élément de suffixe, et que l'élément de préfixe se compose de uns et que l'élément de suffixe soit codé dans un code Exp-Golomb de l'ordre 0.

**6.** Dispositif pour le codage arithmétique de quantités de coefficients de transformation, aux caractéristiques suivantes :

> un dispositif destiné à binariser les quantités des coefficients de transformation en une binarisation, de sorte que, pour les quantités inférieures ou égales à une valeur prédéterminée, la binarisation corresponde à une binarisation unaire et que, pour les quantités supérieures à la valeur prédéterminée, la binarisation se compose d'un élément de préfixe, qui consiste en un nombre de uns correspondant à la valeur prédéterminée, et d'un élément de suffixe, qui représente un élément Exp-Golomb de l'ordre 0 pour la quantité du coefficient de transformation respectif moins la valeur prédéterminée incrémentée de un, la valeur prédéterminée étant de 14 ;

un dispositif destiné à soumettre à un codage arithmétique binaire des décisions binaires de l'élément de suffixe à l'aide d'un contexte non adaptatif ; et

un dispositif destiné à soumettre à un codage arithmétique binaire au moins une décision binaire de la binarisation correspondant à une binarisation unaire ou de l'élément de préfixe à l'aide d'un contexte avec adaptation.

7. Dispositif pour le décodage arithmétique de quantités de coefficients de transformation qui sont binarisées de sorte que, pour les quantités inférieures ou égales à une valeur prédéterminée, la binarisation corresponde à une binarisation unaire et que, pour les quantités supérieures à la valeur prédéterminée, la binarisation se compose d'un élément de préfixe, qui consiste en un nombre de uns correspondant à la valeur prédéterminée, et d'un élément de suffixe, qui représente un élément Exp-Grolomb de l'ordre 0 pour la quantité du coefficient de transformation respectif moins la valeur prédéterminée incrémentée de un, la valeur prédéterminée étant de 14, aux caractéristiques suivantes :

un dispositif destiné à soumettre à un décodage arithmétique binaire des décisions binaires de l'élément de suffixe à l'aide d'un contexte non adaptatif ; et

un dispositif destiné à soumettre à un décodage arithmétique binaire au moins une décision binaire de la binarisation correspondant à une binarisation unaire ou de l'élément de préfixe à l'aide d'un contexte avec adaptation.

8. Programme d'ordinateur permettant à un ordinateur, après qu'il ait été chargé dans la mémoire de l'ordinateur, d'exécuter un procédé selon l'une des revendications 1 à 5.

9. Support de mémoire pouvant être lu dans un ordinateur, sur lequel est mémorisé un programme permettant à un ordinateur, après qu'il ait été chargé dans la mémoire de l'ordinateur, d'exécuter un procédé selon l'une des revendications 1 à 5.

**CBP4**

**Signifikanz-Abbildung**

```
for (i=0; i<max_koeff[type]-1; i++)
{
    Kodiere Signifikanz-Bit (SIG[i])

    if (SIG[i])
    {
        Kodiere Block-Ende bit (LAST[i])
        if(LAST[i])
        {
            break
        }
    }
}
```

**Level-Information**

```
for (i=max_koeff[type]-1; i>=0; i--)
{
    if (SIG[i])
    {
        Kodiere ABS[i]
        Kodiere SIGN[i]
    }
}
```

## Figur 1

| Koeffizienten | 14 | 0 | -5 | 3 | 0 | 0 | -1 | 0 | 1 | 0 | 0 | 0 | 0 | 0 | 0 | 0 |
|---|---|---|---|---|---|---|---|---|---|---|---|---|---|---|---|---|
| SIG | 1 | 0 | 1 | 1 | 0 | 0 | 1 | 0 | 1 | | | | | | | |
| LAST | 0 | | 0 | 0 | | | 0 | | 1 | | | | | | | |

| Koeffizienten | 18 | -2 | 0 | 0 | 0 | -5 | 1 | -1 | 0 | 0 | 0 | 0 | 1 | 0 | 0 | 1 |
|---|---|---|---|---|---|---|---|---|---|---|---|---|---|---|---|---|
| SIG | 1 | 1 | 0 | 0 | 0 | 1 | 1 | 1 | 0 | 0 | 0 | 0 | 1 | 0 | 0 | |
| LAST | 0 | 0 | | | | 0 | 0 | 0 | | | | | 0 | | | |

## Figur 2

| ABS. | Binarisierung | | | | | | | | | | | | | | Exp-Golomb-Teil | | | | | |
|------|---|---|---|---|---|---|---|---|---|---|---|---|---|---|---|---|---|---|---|---|
| | Unärer Teil | | | | | | | | | | | | | | | | | | | |
| 1 | | | | | | | | | | | | | | | | | | | | |
| 2 | | | | | | | | | | | | | | | | | | | | |
| 3 | | | | | | | | | | | | | | | | | | | | |
| 4 | | | | | | | | | | | | | | | | | | | | |
| 5 | | | | | | | | | | | | | | | | | | | | |
| 6 | | | | | | | | | | | | | | | | | | | | |
| 7 | | | | | | | | | | | | | | | | | | | | |
| 8 | | | | | | | | | | | | | | | | | | | | |
| 9 | | | | | | | | | | | | | | | | | | | | |
| 10 | | | | | | | | | | | | | | | | | | | | |
| 11 | | | | | | | | | | | | | | | | | | | | |
| 12 | | | | | | | | | | | | | | | | | | | | |
| 13 | | | | | | | | | | | | | | | | | | | | |
| 14 | | | | | | | | | | | | | | | | | | | | |
| 15 | | | | | | | | | | | | | | | 0 | | | | | |
| 16 | | | | | | | | | | | | | | | 1 | 0 | 0 | | | |
| 17 | | | | | | | | | | | | | | | 1 | 0 | 1 | | | |
| 18 | | | | | | | | | | | | | | | 1 | 1 | 0 | 0 | 0 | |
| 19 | | | | | | | | | | | | | | | 1 | 1 | 0 | 0 | 1 | |
| 20 | | | | | | | | | | | | | | | 1 | 1 | 0 | 1 | 0 | |
| 21 | | | | | | | | | | | | | | | 1 | 1 | 0 | 1 | 1 | |
| ... | | | | | | | | | | | | | | | ... | ... | ... | ... | ... | ... |
| bin | 1 | 2 | 3 | 4 | 5 | 6 | 7 | 8 | 9 | 10 | 11 | 12 | 13 | 14 | 15 | 16 | 17 | 18 | 19 | ... |

## Figur 3

| Block-Typen | Koeffizienten-Anzahl | Kategorie |
|---|---|---|
| DC-Luminanz-Block (INTRA 16x16-Mode) | 16 | 0: Luma-Intra16-DC |
| AC-Luminanz-Block (INTRA 16x16-Mode) | 15 | 1: Luma-Intra16-AC |
| Luminanz-Block (INTRA 4x4-Mode) | 16 | 2: Luma-4x4 |
| Luminanz-Block (INTER-Mode) | 16 | |
| DC-Chrominanz-U-Block (INTRA-Mode) | 4 | 3: Chroma-DC |
| DC-Chrominanz-V-Block (INTRA-Mode) | 4 | |
| DC-Chrominanz-U-Block (INTER-Mode) | 4 | |
| DC-Chrominanz-V-Block (INTER-Mode) | 4 | |
| AC-Chrominanz-U-Block (INTRA-Mode) | 15 | 4: Chroma-AC |
| AC-Chrominanz-V-Block (INTRA-Mode) | 15 | |
| AC-Chrominanz-U-Block (INTER-Mode) | 15 | |
| AC-Chrominanz-V-Block (INTER-Mode) | 15 | |

## Figur 4

Figur 5

| Koeffizienten | 14 | 0 | 5 | 3 | 0 | 0 | 1 | 0 | 1 |
|---|---|---|---|---|---|---|---|---|---|
| ctx_number_abs_1bin | 4 | | 4 | 2 | | | 1 | | 0 |
| ctx_number_abs_rbins | 2 | | 1 | 0 | | | | | |

← Umgekehrte Scan-Richtung →

| Koeffizienten | 18 | 2 | 1 | 6 | 4 | 5 | 1 | 1 | 0 | 1 | 0 | 0 | 1 | 0 | 0 | 1 |
|---|---|---|---|---|---|---|---|---|---|---|---|---|---|---|---|---|
| ctx_number_abs_1bin | 4 | 4 | 4 | 4 | 4 | 3 | 3 | 3 | | 2 | | | 1 | | | 0 |
| ctx_number_abs_rbins | 4 | 3 | | 2 | 1 | 0 | | | | | | | | | | |

Figur 6